# FASCICULE DE BREVET EUROPEEN

(11) **EP 3 598 451 B1**
(45) Date de publication et mention de la délivrance du brevet: **25.05.2022**
(21) Numéro de dépôt: 19186098.0
(22) Date de dépôt: 12.07.2019
(51) Int. Cl.: G11C 11/412, G11C 11/417

(54) **MEMOIRE SRAM / ROM RECONFIGURABLE PAR CONNEXIONS AUX ALIMENTATIONS**
SRAM-/ROM-SPEICHER, DER DURCH VERBINDUNGEN ZU DEN VERSORGUNGSANSCHLÜSSEN REKONFIGURIERBAR IST
SRAM/ROM MEMORY RECONFIGURABLE BY CONNECTIONS TO POWER SUPPLIES

(30) Priorité: 13.07.2018 FR 1856515
(43) Date de publication de la demande: 22.01.2020
(73) Titulaire: Commissariat à l'énergie atomique et aux énergies alternatives, 75015 Paris (FR)
(72) Inventeur: MAKOSIEJ, Adam, 38054 GRENOBLE CEDEX 09 (FR); CORIAT, David, 38054 GRENOBLE CEDEX 09 (FR)
(74) Mandataire: Brevalex

(56) Documents cités:
- US-A- 5 040 143
- US-B1- 6 426 890
- US-B1- 7 358 764

## Description

### DOMAINE TECHNIQUE ET ART ANTÉRIEUR

L'invention se rapporte au domaine des mémoires statiques à accès aléatoires SRAM (SRAM pour « Static Random Access Memory »), et concerne plus particulièrement celui des mémoires, dotées de cellules ayant une structure de SRAM, et susceptibles également d'intégrer une fonction de mémoire ROM pour (« Read-Only Memory » ou « mémoire en lecture seule ») ou une mémoire NVM, c'est-à-dire une mémoire non volatile.

Dans ce domaine, le document US 5365475 présente une cellule mémoire ayant une structure de SRAM à 6 transistors susceptible, à l'aide d'une ligne d'alimentation supplémentaire et d'une ligne de masse supplémentaire, d'être utilisée, par le biais d'une polarisation figée de ses transistors, comme une cellule de mémoire ROM. Le comportement en mode ROM ou SRAM conventionnel de la cellule est figé, lors de la fabrication de la mémoire, en choisissant la manière dont celle-ci est connectée aux lignes d'alimentation et lignes de masses. Le document US 7 358 764 B1 présente un autre exemple de cellule mémoire SRAM.

Par ailleurs, pour effectuer son démarrage, un système numérique utilise des données qui sont typiquement stockées dans un espace d'une mémoire ROM. Une fois ce démarrage effectué, pendant le fonctionnement du système, cet espace mémoire ROM est généralement inutilisé.

Le document « Area Efficient ROM-Embedded SRAM Cache », de Dongsoo Lee et al., IEEE Transactions on VLSI systems, vol. 21, n°9, 2013 présente quant à lui une mémoire formée à partir de cellules SRAM aptes à fonctionner selon un mode mémoire SRAM conventionnel lors duquel les cellules sont accessibles en lecture et en écriture, et susceptibles également d'adopter un autre mode de fonctionnement lors duquel elles sont accessibles en lecture seule. Le passage d'un mode à l'autre, est réalisé à l'aide d'une ligne de mot supplémentaire dont on modifie la polarisation. Cette ligne de mot supplémentaire nécessite une modification substantielle des circuits de commande externes à la matrice de cellules, et en particulier du pilote de lignes de mots et de la logique de contrôle associée.

Il se pose donc le problème de trouver un nouveau dispositif mémoire doté d'une fonctionnalité de mémoire ROM et qui soit amélioré vis-à-vis d'inconvénients mentionnés ci-dessus, en particulier qui soit reconfigurable ou réutilisable, avec un encombrement réduit, et ne nécessite pas une modification substantielle de circuits de commande externes.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels:

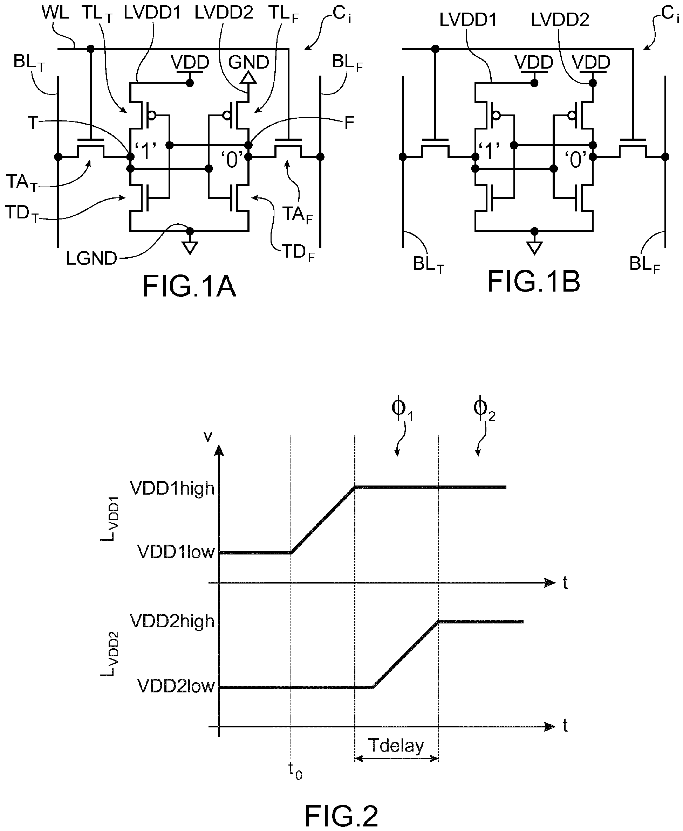

- les figures 1A-1B donnent un schéma électrique équivalent d'une première cellule mémoire appartenant à un plan mémoire d'un dispositif mémoire suivant l'invention durant deux phases consécutives lors desquelles, au moyen de lignes d'alimentation des inverseurs et de signaux appliqués sur ces lignes, on pré-charge une information logique dans la première cellule avant de lui rendre une fonctionnalité de cellule SRAM accessible en lecture et en écriture ;
- la figure 2 donne un exemple de chronogramme de tensions susceptibles d'être appliquées à une première ligne d'alimentation et à une deuxième ligne d'alimentation des inverseurs d'une cellule mémoire durant les deux phases consécutives précitées ;

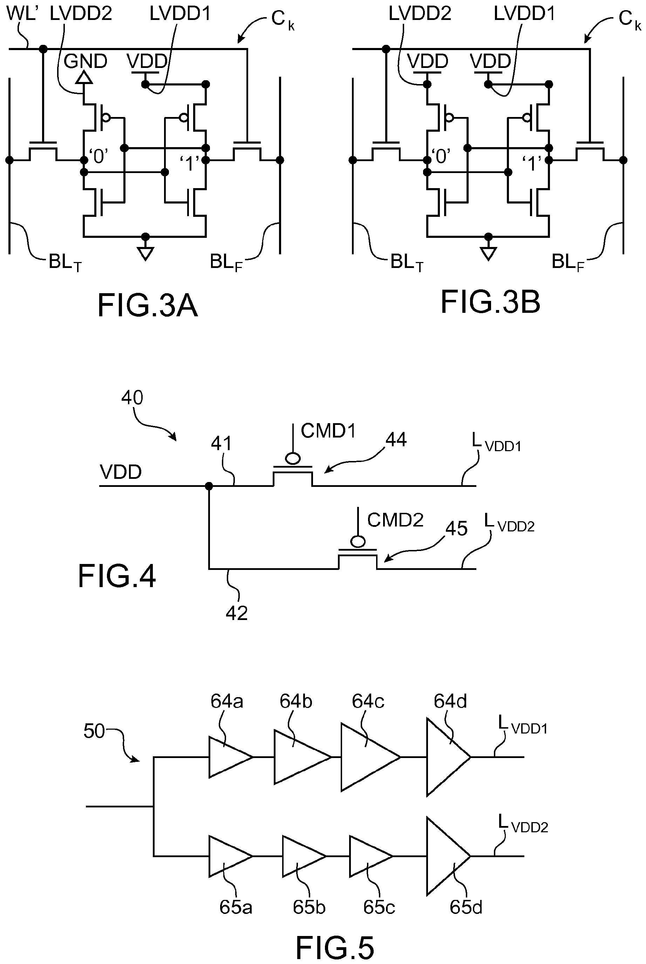

- les figures 3A-3B donnent un schéma électrique équivalent d'une autre cellule mémoire du même dispositif que la première et durant les deux mêmes phases consécutives, cette autre cellule ayant une connexion aux lignes d'alimentation des inverseurs différente de celle de la première afin de pré-charger une information logique différente de celle pré-chargée dans la première cellule ;
- les figures 4, 5, 6 donnent respectivement un premier exemple, un deuxième exemple, et un troisième exemple de réalisation d'un circuit permettant d'appliquer une séquence de tensions d'alimentation aux première et deuxième lignes d'alimentation durant les deux phases précitées ;

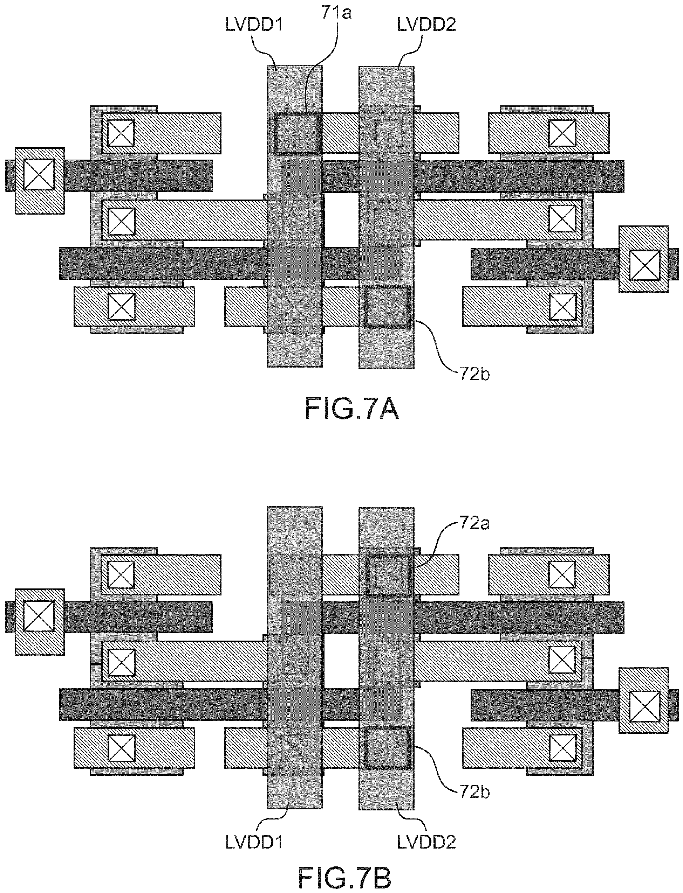

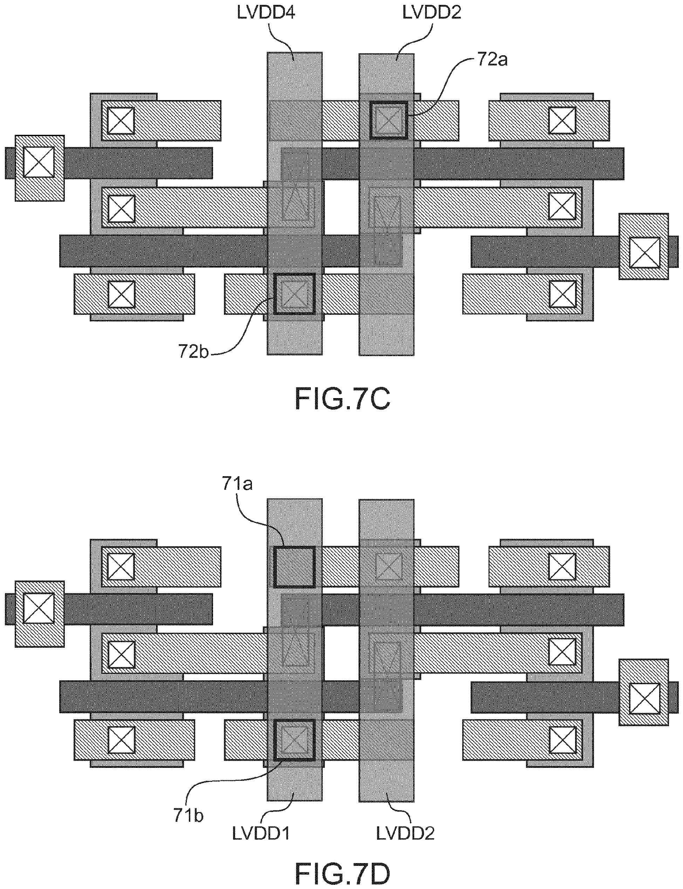

- les figures 7A-7D servent à illustrer des configurations possibles de connexions d'une cellule à la première ligne d'alimentation et à la deuxième ligne d'alimentation ;

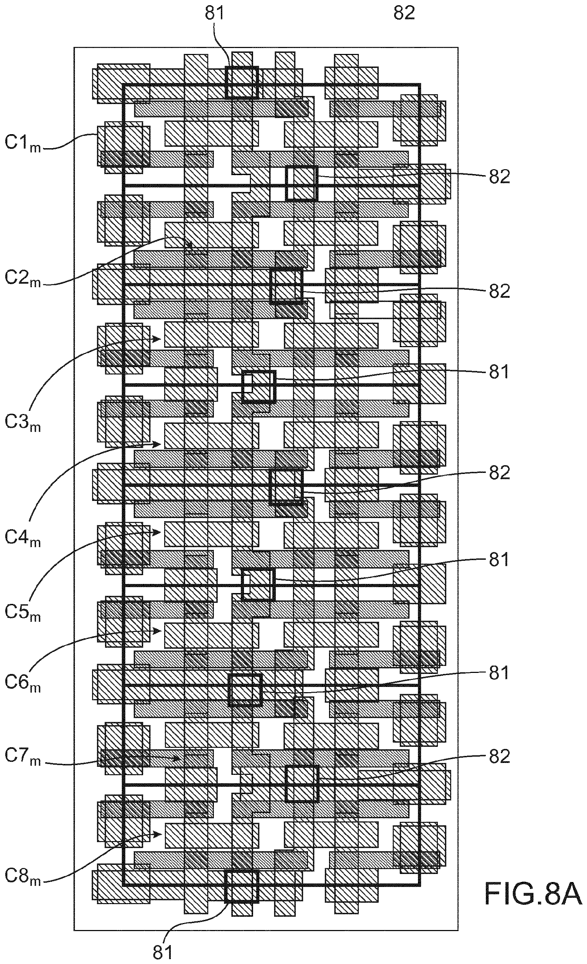

- les figures 8A-8B donnent un exemple d'agencement particulier de cellules mémoires dans une colonne d'un dispositif mémoire dans lequel une cellule sur deux de la colonne est pré-chargeable pour être lisible telle une ROM, puis réinscriptible par la suite, tandis que les autres cellules adoptent un fonctionnement de cellule SRAM conventionnelle ;

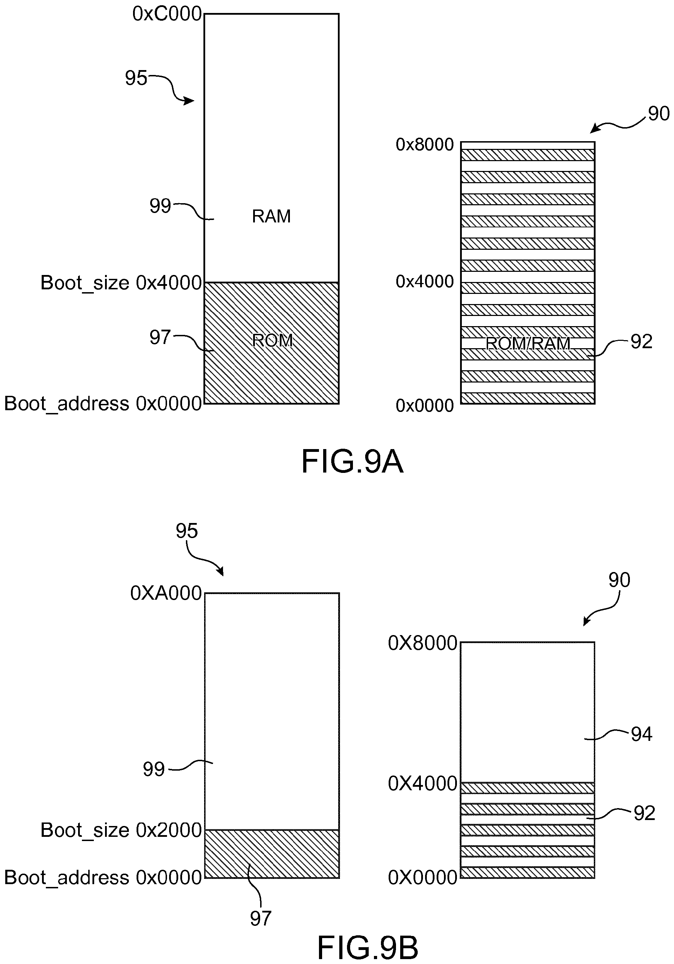

- les figures 9A-9B servent à illustrer un exemple de correspondance entre un ensemble d'adresses virtuelles relatives à une mémoire RAM, et une mémoire physique telle que mise en œuvre suivant un mode de réalisation de la présente invention comportant un secteur de cellules SRAM et un secteur de cellules SRAM dont certaines sont pré-chargeables telles des cellules de mémoire ROM ;

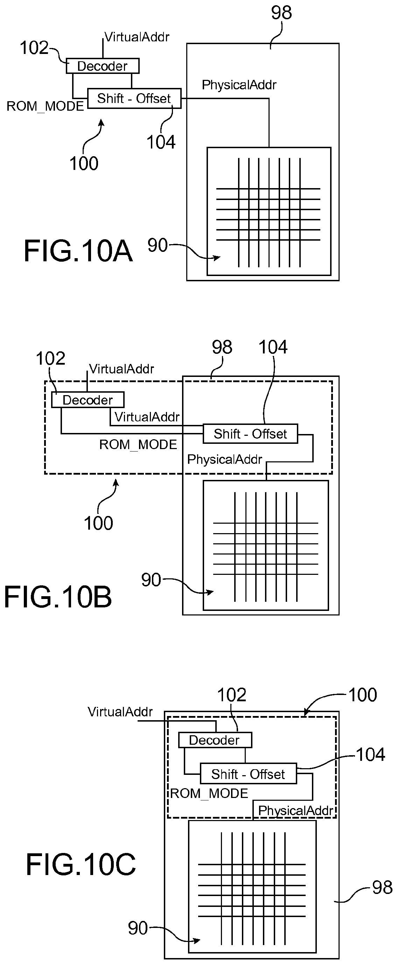

- les figures 10A-10C donnent différents exemples de réalisation d'un module de conversion d'adresse mémoire virtuelle en adresse physique pour un dispositif mémoire tel que mis en œuvre suivant un mode de réalisation de la présente invention ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DE L'INVENTION

L'invention est définie dans la revendication 1. Un exemple de réalisation de la présente invention prévoit un dispositif mémoire doté :
- d'un ensemble de cellules mémoires chaque cellule mémoire dudit ensemble comprenant :
- un premier nœud et un deuxième nœud,
- un premier inverseur et un deuxième inverseur connectés de façon croisée entre ledit premier nœud et ledit deuxième nœud,
le dispositif mémoire comprenant en outre :
- une première ligne d'alimentation connectée à l'un parmi un premier transistor du premier inverseur et un deuxième transistor du deuxième inverseur,

- une deuxième ligne d'alimentation connectée à l'autre parmi ledit premier transistor du premier inverseur et ledit deuxième transistor du deuxième inverseur, la deuxième ligne d'alimentation étant distincte de la première ligne d'alimentation,
le dispositif mémoire étant doté d'un circuit configuré pour, lors d'une séquence d'initialisation :
- pendant une première phase appliquer un premier couple de potentiels, respectivement sur la première ligne d'alimentation et la deuxième ligne d'alimentation, de sorte à imposer à des cellules dudit ensemble, des données logiques de pré-charge dont les valeurs respectives dépendent de la ligne de d'alimentation parmi lesdites première et deuxième lignes d'alimentation à laquelle son premier transistor et son deuxième transistor sont respectivement connectées, puis
- pendant une deuxième phase appliquer un deuxième couple de potentiels respectivement sur ladite première ligne d'alimentation et la deuxième ligne d'alimentation, le deuxième couple de potentiels étant différent du premier couple de potentiels et prévu de sorte à de sorte à maintenir ces données logiques de pré-charge et rendre les cellules dudit ensemble accessibles en lecture et en écriture.

Les cellules dudit ensemble sont ainsi pré-chargées automatiquement de par la séquence de potentiels appliqués sur la première ligne d'alimentation et la deuxième ligne d'alimentation, selon des valeurs respectives qui dépendent de leurs agencements respectifs vis-à-vis de la première ligne d'alimentation et de la deuxième ligne d'alimentation.

L'agencement de chaque cellule vis-à-vis des lignes d'alimentation et la valeur de donnée pré-chargée associée à cet agencement sont typiquement déterminés lors de la conception du dispositif. Ces données de pré-charge peuvent ainsi constituer des données d'une mémoire ROM ou NVM ou un code de mémoire ROM ou NVM qui est automatiquement imposé à l'ensemble de cellules consécutivement à la séquence d'initialisation.

Ainsi, sans devoir nécessairement modifier le décodeur de lignes interne de la mémoire et tout en limitant l'encombrement, ce circuit permet d'utiliser les cellules dudit ensemble comme cellules de mémoire ROM ou NVM, puis, une fois que des ou les données de la mémoire ROM ou NVM sont lues, utiliser ces cellules comme cellules d'une mémoire SRAM fonctionnant de manière conventionnelle.

Un tel pré-chargement des cellules a également un intérêt pour des applications différentes de celles indiquées ci-dessus. Par exemple, il un tel pré-chargement peut être utilisé pour protéger le dispositif mémoire vis-à-vis d'une lecture non autorisée. Par exemple, le dispositif mémoire peut détecter la mise en œuvre d'une lecture non-autorisée et lorsqu'une telle lecture est détectée, la séquence d'initialisation peut être mise en œuvre afin d'effacer rapidement le contenu des cellules mémoires.

Avantageusement, la séquence d'initialisation peut être consécutive à une mise sous tension d'un système dans lequel le dispositif mémoire est intégré.

Ainsi, le circuit permettant d'établir la séquence d'initialisation définie plus haut peut être configuré pour :
- pendant la première phase appliquer le premier couple de potentiels en mettant sous tension la première ligne d'alimentation sans alimenter la deuxième ligne d'alimentation, puis, après un retard prédéterminé par rapport au début de la première phase,
- selon la deuxième phase, appliquer le deuxième couple de potentiels en maintenant sous tension la première ligne d'alimentation tout en mettant sous tension la deuxième ligne d'alimentation, la première ligne d'alimentation et la deuxième ligne d'alimentation pouvant être alors mises au même potentiel.

Selon une première possibilité de mise en œuvre, un tel circuit peut comprendre :
- une première portion de circuit et une deuxième portion de circuit recevant chacune une tension d'alimentation VDD,
- un premier élément interrupteur, typiquement doté d'au moins un transistor, entre la première portion et la première ligne d'alimentation, apte à alternativement déconnecter puis connecter la première portion de circuit à la première ligne d'alimentation suite à un changement d'état d'un premier signal de commande,
- un deuxième élément interrupteur, typiquement doté d'au moins un autre transistor, agencé entre la deuxième portion et la deuxième ligne d'alimentation, apte à alternativement déconnecter puis connecter la deuxième portion de circuit à la deuxième ligne d'alimentation suite à un changement d'état d'un deuxième signal de commande, le changement d'état du deuxième signal de commande étant retardé, selon ledit retard prédéterminé, par rapport au changement d'état du premier signal de commande.

Selon une deuxième possibilité de mise en œuvre, un tel circuit peut comprendre :
- une première portion et une deuxième portion recevant chacune une tension d'alimentation VDD,
- au moins un premier circuit tampon entre la première portion et la première ligne d'alimentation,
- au moins un deuxième circuit tampon entre la deuxième portion et la deuxième ligne d'alimentation, ledit premier tampon ayant un gain en courant différent de celui du deuxième tampon.

Selon une troisième possibilité de mise en œuvre, un tel circuit peut comprendre :
- une première portion connectée à la première ligne d'alimentation et à un nœud recevant une tension d'alimentation VDD,
- une deuxième portion connectée audit nœud, au moins une cellule à retard étant disposée entre la deuxième portion et la deuxième ligne d'alimentation.

De plus, deux cellules mémoires voisines dudit ensemble de cellules mémoire partagent une première zone de connexion commune à l'une desdites première ligne d'alimentation ou deuxième ligne d'alimentation choisie en fonction de la valeur souhaitée de la donnée logique de pré-charge à imposer à l'une des deux cellules mémoires voisines dudit ensemble au cours de la première phase de la séquence d'initialisation. En effet, étant donné que deux cellules mémoires voisines partagent une zone de connexion commune à l'une des première et deuxième lignes d'alimentation, il est donc possible de choisir la valeur de pré-charge qui sera imposée à l'une des deux cellules mémoires voisines en choisissant la ligne d'alimentation (la première ou la deuxième) qui sera couplée au premier transistor du premier inverseur, l'autre ligne d'alimentation se retrouvant couplée au deuxième transistor du deuxième inverseur. Pour l'autre des deux cellules mémoires voisines, il y a dans ce cas deux possibilités :
- soit le premier transistor du premier inverseur et le deuxième transistor du deuxième inverseur de cette autre des deux cellules mémoires voisines sont couplés tous les deux à la ligne d'alimentation qui est couplée à la première zone de connexion commune, ce qui signifie que la valeur de pré-charge ne peut pas être imposée pour cette autre des deux cellules mémoires voisines (comme pour une cellule SRAM conventionnelle) ;
- soit le premier transistor du premier inverseur et le deuxième transistor du deuxième inverseur de cette autre des deux cellules mémoires voisines sont couplés aux deux lignes d'alimentation de manière opposée à ladite une des deux cellules mémoires voisines (si le premier inverseur de la première cellule est couplé à la première ligne d'alimentation et le deuxième inverseur de la première cellule est couplé à la deuxième ligne d'alimentation, alors le premier inverseur de la deuxième cellule est couplé à la deuxième ligne d'alimentation et le deuxième inverseur de la deuxième cellule est couplé à la première ligne d'alimentation, ou bien lorsque le premier inverseur de la première cellule est couplé à la deuxième ligne d'alimentation et le deuxième inverseur de la première cellule est couplé à la première ligne d'alimentation, alors le premier inverseur de la deuxième cellule est couplé à la première ligne d'alimentation et le deuxième inverseur de la deuxième cellule est couplé à la deuxième ligne d'alimentation), ce qui signifie que la valeur de pré-charge imposée pour cette autre des deux cellules mémoires voisines n'est pas choisie indépendamment de celle choisie pour ladite une des deux cellules mémoires voisines.

Bien que cette configuration ne permet de choisir la valeur de pré-charge que pour une seule des deux cellules mémoires qui ont une zone de connexion commune, elle a pour avantage de ne pas augmenter la surface occupée par les cellules mémoires, contrairement au cas où les valeurs de pré-charge de chacune des cellules mémoires sont choisies indépendamment des autres cellules mémoires (ce qui ne peut pas être obtenue avec une zone de connexion commune).

Typiquement, le dispositif comporte au moins une première cellule dudit ensemble ayant son premier inverseur connecté à la première ligne d'alimentation et son deuxième inverseur connecté à la deuxième ligne d'alimentation et au moins une autre cellule ayant son premier inverseur connecté à la deuxième ligne d'alimentation et son premier inverseur connecté à la deuxième ligne d'alimentation. Dans ce cas, cette autre cellule stocke une donnée de valeur complémentaire de celle stockée par la première cellule.

Le dispositif mémoire peut également comporter une autre cellule ayant ses deux inverseurs connectés à une même ligne d'alimentation donnée parmi lesdites première ligne d'alimentation et deuxième ligne d'alimentation. Dans ce cas, cette autre cellule est polarisée comme une cellule SRAM conventionnelle immédiatement après la séquence d'initialisation.

Un exemple de réalisation prévoit ainsi que l'ensemble de cellules peut comporter une deuxième cellule voisine de la première cellule et ayant ses deux inverseurs connectés à une même ligne d'alimentation donnée parmi lesdites première ligne d'alimentation et deuxième ligne d'alimentation, la première cellule et la deuxième cellule partageant une première zone de connexion commune connectée à ladite ligne d'alimentation donnée. Une telle zone de connexion commune permet de réduire l'encombrement et peut permettre de réaliser les différentes connexions aux lignes d'alimentation dans une technologie de fabrication standard.

L'ensemble de cellules peut comporter une troisième cellule située sur une même colonne de cellules que la première cellule et la deuxième cellule de sorte que la deuxième cellule est située entre la première cellule et la troisième cellule, la troisième cellule ayant un de ses inverseurs connecté à la première ligne d'alimentation et un autre de ses inverseurs connecté à la deuxième ligne d'alimentation. Ainsi, la troisième cellule est pré-chargeable et peut être utilisée comme cellule de mémoire ROM ou NVM.

La troisième cellule peut être une cellule voisine de la deuxième cellule et partager avec la deuxième cellule une deuxième zone de connexion commune, la deuxième zone de connexion commune étant connectée à la première ligne d'alimentation lorsque la première zone de connexion commune est connectée à la première ligne d'alimentation ou bien la deuxième zone de connexion commune étant connectée à la deuxième ligne d'alimentation lorsque la première zone de connexion commune est connectée à la deuxième ligne d'alimentation.

En variante, la troisième cellule peut être une cellule voisine de la deuxième cellule et peut partager avec la deuxième cellule une deuxième zone de connexion commune, la deuxième zone de connexion commune étant couplée à la première ligne d'alimentation lorsque la première zone de connexion commune est couplée à la deuxième ligne d'alimentation ou bien la deuxième zone de connexion commune étant couplée à la deuxième ligne d'alimentation lorsque la première zone de connexion commune est couplée à la première ligne d'alimentation. Cette configuration peut être avantageuse lorsque les cellules mémoires ont deux à deux des designs symétriques, ce qui permet d'appliquer une même valeur de pré-charge à toutes les cellules mémoires se trouvant dans une telle configuration.

L'ensemble de cellules peut être doté d'au moins une quatrième cellule disposée sur une même colonne de cellules que la première cellule, la deuxième cellule et la troisième cellule, la quatrième cellule ayant des inverseurs connectées à la deuxième ligne d'alimentation.

Avantageusement, le dispositif mémoire suivant l'invention peut être doté d'un premier secteur comportant ledit ensemble de cellules, autrement dit avec des cellules pouvant fonctionner comme des cellules RAM pré-chargeables et susceptibles d'adopter ainsi le mode de fonctionnement décrit précédemment, et un deuxième secteur comportant des cellules mémoires utilisées uniquement comme cellules SRAM conventionnelles.

Ce deuxième secteur peut être formé de cellules SRAM dotées d'inverseurs connectées à une même ligne d'alimentation parmi les lignes d'alimentation LVDD1, LVDD2 ou recevant un même potentiel d'alimentation pendant la première phase et pendant la deuxième phase, ou connectés de manière arbitraire pour pré-charger des valeurs arbitraires dont on ne se sert pas lors de la lecture de la mémoire ROM ou NVM.

Avantageusement, ledit ensemble de cellules appartient à un plan matriciel agencé en colonnes et en rangées horizontales (alternativement paire et impaire) de cellules. Le dispositif mémoire est alors avantageusement configuré de sorte qu'une rangée horizontale sur deux de cellules constitue une mémoire ROM ou NVM consécutivement à la phase d'initialisation décrite précédemment.

Dans ce cas, lorsque la première cellule appartient à une rangée horizontale impaire de cellules, d'autres cellules dudit ensemble appartenant à d'autres rangées impaires sont également pré-chargeables.

En variante, lorsque la première cellule mémoire appartient à une rangée horizontale paire de cellules, d'autres cellules dudit ensemble appartenant à d'autres rangées paires sont également pré-chargeables.

Pour permettre l'accession à des cellules servant successivement de cellules de mémoire ROM ou NVM puis de mémoire RAM, le dispositif mémoire peut comprendre en outre un module de conversion d'adresse mémoire virtuelle en adresse mémoire physique. Un tel module de conversion peut servir notamment lorsque les cellules servant de mémoire ROM ou NVM ne sont pas agencées successivement les unes à côté des autres.

Ce module de conversion peut être doté d'un module de décalage configuré pour :
lors d'un accès à une cellule pré-chargée, typiquement lors du redémarrage d'un circuit, détecter un signal indicateur d'un premier type d'accès mémoire (ROM) relatif à un accès à des cellules mémoires accessibles en lecture seule dudit ensemble, et à appliquer en conséquence un premier type d'opération de décalage à une adresse virtuelle afin de produire une adresse physique, puis,
lors d'un accès SRAM, typiquement après redémarrage ou amorçage (boot) du système, détecter un signal indicateur d'un deuxième type d'accès mémoire (RAM), relatif à un accès à des cellules mémoires accessibles en lecture et en écriture dudit ensemble, et à appliquer en conséquence un deuxième type d'opération de décalage à une adresse virtuelle afin de produire une adresse physique, le deuxième type d'opération de décalage étant différent dudit premier type d'opération de décalage.
Le premier type d'opération de décalage peut être prévu de sorte à restreindre l'accès uniquement à des rangées horizontales paires parmi lesdites rangées horizontales dudit ensemble de cellules ou à restreindre l'accès uniquement à des rangées horizontales impaires parmi lesdites rangées horizontales dudit ensemble de cellules, tandis que le deuxième type d'opération de décalage est susceptible de donner accès à l'intégralité des rangées horizontales dudit ensemble de cellules.

Le module de conversion peut comporter un décodeur configuré pour :
- à partir d'une adresse virtuelle, produire le signal indicateur d'un premier type d'accès mémoire relatif ou un signal indicateur d'un deuxième type d'accès mémoire,
- transmettre cette adresse virtuelle au module de décalage.

On peut prévoir d'intégrer l'ensemble de cellules, ledit module de décalage, et avantageusement le décodeur sur un même support.

Dans tous les cas, il est possible que la séquence d'initialisation ne soit appliquer qu'à une ou certaines colonnes de cellules mémoires du dispositif. Pour cela, il est possible que le dispositif mémoire soit doté d'un ou plusieurs interrupteurs agencés en amont de la ou des colonnes afin de commander le couplage ou non des cellules mémoires avec les lignes d'alimentation.

Le dispositif mémoire peut notamment servir de mémoire cache dont certaines colonnes peuvent être réinitialisées.

### EXPOSÉ DÉTAILLÉ DE MODES DE RÉALISATION PARTICULIERS

On se réfère à présent aux figures 1A-1B, et 2 qui servent à illustrer différentes phases d'une séquence d'initialisation d'une cellule mémoire Cᵢ élémentaire d'un dispositif mémoire tel que mis en œuvre suivant un exemple de réalisation de la présente invention. Lors de cette séquence initialisation, une information logique est pré-chargée et imposée à cette cellule Cᵢ. Cette information ou donnée logique correspond à une donnée de mémoire ROM.

La cellule mémoire Cᵢ représentée a une structure de mémoire SRAM et est ainsi dotée de deux nœuds T et F, prévus pour conserver une information logique sous forme d'une première donnée logique, et d'une deuxième donnée logique complémentaire de la première donnée. Le maintien des données logiques dans les nœuds T, F est assuré par des transistors TL_{T}, TL_{F}, TD_{T}, TD_{F} formant des inverseurs bouclés sur eux-mêmes, c'est à dire montés en antiparallèle ou tête bêche. Ainsi, un premier inverseur est doté d'une entrée connectée au premier nœud et à une sortie d'un autre inverseur, le premier inverseur ayant en outre une sortie connectée au deuxième nœud et à une entrée de l'autre inverseur. Cet autre inverseur est donc doté d'une entrée connectée au deuxième nœud et d'une sortie connectée au premier nœud.

Dans l'exemple de réalisation illustré, la cellule SRAM a une structure de type communément appelée « 6T » et comporte ainsi 6 transistors, les deux inverseurs étant alors réalisés par deux transistors de charge TL_{T}, TL_{F}, dans cet exemple de type PMOS, et également appelés « pull up », et deux transistors de conduction, dans cet exemple de type NMOS et également appelés « pull down ». Les transistors TL_{T}, TD_{T}, forment un côté de la cellule, tandis que les transistors TL_{F}, TD_{F}, forment ici un autre côté de la cellule.

La cellule Cᵢ est également dotée de deux transistors d'accès TA_{T} et TA_{F} ayant un agencement conventionnel. Les transistors d'accès TA_{T} et TA_{F} sont connectés respectivement à des lignes dites de bit BL_{T} et BL_{F} généralement partagées par les cellules SRAM d'une même colonne de cellules d'un plan matriciel formé de cellules agencées en lignes (rangées horizontales) et en colonnes (rangées verticales). L'accès aux nœuds T et F est commandé par une ligne de mot WL généralement partagée par des ou les cellules SRAM d'une même ligne (rangée horizontale) de cellules du plan matriciel. Les transistors d'accès TA_{T} et TA_{F} sont ainsi prévus pour permettre l'accès ou bloquer l'accès respectivement au premier nœud T et au deuxième nœud F.

Dans l'exemple de réalisation illustré, la cellule Ci a la particularité d'avoir son premier inverseur et le deuxième inverseur qui ne sont pas reliés à une même ligne d'alimentation mais connectés respectivement à une première ligne d'alimentation LVDD1 et à une deuxième ligne d'alimentation LVDD2 distincte de la première ligne d'alimentation LVDD1. Les lignes d'alimentation LVDD1, LVDD2 sont susceptibles d'être mises à des potentiels différents l'une de l'autre.

Dans cet exemple de réalisation particulier, un premier transistor de charge TL_{T} ici de type PMOS est connecté à la première ligne d'alimentation LVDD1 tandis qu'un deuxième transistor de charge TL_{F} est connecté à la deuxième ligne d'alimentation LVDD2, ces transistors TL_{T},TL_{F} pouvant être ainsi polarisés de manière différente l'un par rapport à l'autre, tandis que les transistors de conduction TD_{T}, TD_{F}, en particulier de type NMOS sont quant à eux connectés à une même ligne LGND, qui peut être mise par exemple à un potentiel de référence ou de masse GND.

Durant une première phase Φ1 d'une séquence d'initialisation (figure 1A, et chronogramme de la figure 2), un premier potentiel VDD1high, dans cet exemple égal à la tension d'alimentation VDD, est appliqué sur la première ligne d'alimentation LVDD1, tandis qu'un deuxième potentiel VDD2low différent du premier potentiel, dans cet exemple égal au potentiel de masse GND, est appliqué à la deuxième ligne d'alimentation LVDD2.

L'application de ce couple de potentiels différents entraine une polarisation dissymétrique des transistors de charge des inverseurs l'un par rapport à l'autre. Une alimentation dissymétrique ou déséquilibrée d'un côté de la cellule par rapport à l'autre permet d'imposer aux nœuds T, F des valeurs de pré-charge. La donnée logique pré-chargée est alors imposée aux nœuds T, F sans faire appel aux lignes de bits dont on se sert habituellement pour écrire ou lire une donnée lorsque la cellule Cᵢ se retrouve dans son mode de fonctionnement normal autrement dit celui d'une SRAM conventionnelle.

La cellule Ci est initialisée durant la première phase Φ1 comme une cellule de mémoire ROM. Le couple de potentiels VDD, GND appliqués respectivement sur la première ligne LVDD1 et LVDD2 entraine dans cet exemple une pré-charge des deux nœuds T et F, respectivement à un niveau logique '1' et au niveau logique complémentaire '0'. Une information logique est ainsi pré-chargée dans la cellule Cᵢ, et sa valeur dépend de la manière dont la cellule Ci est connectée aux lignes d'alimentations LVDD1, LVDD2 et du couple de potentiels appliqués sur celles-ci lors de la première phase.

Avantageusement, la première phase lors de laquelle la cellule Cᵢ est initialisée et pré-chargée, est consécutive à une mise sous tension du dispositif mémoire (mise sous tension se produisant dans l'exemple de chronogramme donné sur la figure 3 à un instant t₀).

Dans ce cas, si l'on se rapporte à l'exemple donné précédemment, la mise sous tension du dispositif mémoire entraine une mise au potentiel d'alimentation VDD de la première ligne d'alimentation LVDD1 tandis que la deuxième ligne d'alimentation LVDD2 n'est pas alimentée et laissée au potentiel de masse GND pendant la première phase.

Selon une deuxième phase Φ2 (figure 1B et chronogramme de la figure 2), on établit une alimentation symétrique des transistors de charge des inverseurs. Pour cela, le couple de potentiels appliqués respectivement sur la première ligne d'alimentation LVDD1 et sur la deuxième ligne d'alimentation LVDD2 est modifié.

Pour cette deuxième phase, on maintient par exemple un potentiel VDD1high égal au potentiel d'alimentation VDD sur la première ligne LVDD1 tandis que sur la deuxième ligne d'alimentation LVDD2, un potentiel supérieur VDD2high de celui prévu pour la première phase est appliqué. La deuxième ligne d'alimentation LVDD2 est par exemple mise au potentiel d'alimentation VDD, si bien que les transistors de charge TL_{T} et TL_{F} ont leurs sources au même potentiel, comme c'est le cas pour une cellule SRAM conventionnelle.

Ainsi, durant la deuxième phase, la cellule Ci maintient la donnée logique pré-chargée imposée lors de la première phase tout en devenant, par le biais d'une alimentation équilibrée ou symétrique entre les deux côtés de la cellule, équivalente à une cellule SRAM alors accessible en lecture et en écriture.

Lorsque la première phase Φ1 résulte d'une mise sous tension du dispositif mémoire, la deuxième phase Φ2 lors de laquelle la cellule Ci devient accessible en lecture et en écriture peut être mise en œuvre par une mise sous tension retardée de la deuxième ligne d'alimentation LVDD2 selon un retard prédéterminé T_{delay}.

Des exemples de réalisation d'un circuit permettant d'appliquer les potentiels aux lignes LVDD1, LVDD2 lors des différentes phases de la séquence d'initialisation précité, et permettre en particulier une telle mise sous tension retardée, seront donnés ultérieurement.

Les figures 3A-3B servent à illustrer le fonctionnement d'une autre cellule Cₖ élémentaire du dispositif mémoire durant les mêmes première phase Φ1 et deuxième phase Φ2 de la séquence d'initialisation.

Cette autre cellule Cₖ appartenant au même agencement matriciel que la cellule Cᵢ, et en particulier à la même colonne de cellules que la cellule Ci, diffère de la cellule Ci de par sa connexion aux lignes d'alimentation LVDD1 et LVDD2.

Dans cet exemple, le premier inverseur et le deuxième inverseur de la cellule Cₖ, sont connectés respectivement cette fois à la deuxième ligne d'alimentation LVDD2 et à la première ligne d'alimentation LVDD1. Ainsi, la source du premier transistor de charge TL_{T} est connectée à la deuxième ligne d'alimentation LVDD2 tandis que la source du transistor de charge TL_{F} est connectée à la première ligne d'alimentation LVDD1.

Si l'on suit l'exemple de polarisation des lignes d'alimentation LVDD1, LVDD2 précédemment décrit pour la première phase, des potentiels VDD et GND sont appliqués respectivement sur la première ligne LVDD1 et la deuxième ligne d'alimentation LVDD2. Cela entraine une mise des deux nœuds de stockage T et F de la cellule Cₖ, respectivement à un niveau logique '0' et au niveau logique '1' fixes. Durant la première phase (figure 3A), la cellule Cₖ est ainsi également pré-chargée comme une cellule de mémoire ROM, mais, du fait de sa connexion différente relativement aux lignes d'alimentation LVDD1, LVDD2, stocke une information logique différente et en particulier complémentaire de celle de la cellule Cᵢ à ses nœuds T, F,

Lors de la deuxième phase Φ2 (figure 3B), la cellule Cₖ est mise dans un mode de fonctionnement de mémoire SRAM, dans la mesure où les potentiels appliqués respectivement sur la première ligne d'alimentation LVDD1 et sur la deuxième ligne d'alimentation LVDD2 sont de préférence égaux, par exemple à VDD, et que l'on obtient une symétrie d'alimentation entre les deux côtés de la cellule permettant de la rendre accessible à la fois en lecture et en écriture.

Le mode de fonctionnement des cellules Cᵢ, Cₖ décrit précédemment peut permettre la mise en œuvre d'un dispositif mémoire fonctionnant telle une SRAM pré-chargée avec des données de mémoire ROM grâce à une séquence d'initialisation. Il est alors possible de lire des données stockées par ces cellules Ci, Ck. Ces données sont par exemple des données relatives à un programme d'amorçage (« Boot » selon la terminologie anglo-saxonne) requis par exemple par un processeur lors du démarrage ou d'une réinitialisation d'un système numérique.

Les lignes d'alimentation LVDD1, LVDD2 permettent en particulier d'initialiser la première cellule Cᵢ et de lui imposer hors son mode de fonctionnement en SRAM conventionnel, et en particulier préalablement à ce mode de fonctionnement en SRAM, une donnée logique de pré-charge. La valeur de cette donnée logique d'initialisation dépend des signaux appliqués sur les lignes d'alimentation et pour un couple de signaux donné, de la manière dont la cellule Cᵢ est connectée aux lignes d'alimentation. La valeur de cette donnée logique imposée lors de la séquence d'initialisation précitée peut être ainsi déterminée dès la conception du dispositif. La donnée logique imposée lors de la séquence d'initialisation constitue ainsi une donnée de mémoire ROM. L'ensemble des données de mémoire ROM ou code de mémoire ROM peut être alors déterminé par le concepteur du dispositif lorsqu'il choisit, au moment de la conception, la manière dont chaque cellule est agencée vis-à-vis des lignes d'alimentation LVDD1 et LVDD2.

Un exemple de réalisation particulier d'un circuit configuré pour appliquer des couples de potentiels différents aux lignes d'alimentation LVDD1 et LVDD2 et permettre de passer de ladite première phase à ladite deuxième phase évoquées précédemment, est illustré sur la figure 4.

Ce circuit 40 permet en particulier de réaliser une mise sous tension retardée d'une des lignes d'alimentation par rapport à l'autre, dans cet exemple de la deuxième ligne d'alimentation LVDD2 par rapport à la ligne d'alimentation LVDD1. Le circuit comprend une première portion 41 et une deuxième portion 42 connectées entre elles et à un nœud recevant une tension d'alimentation VDD. Un élément interrupteur commandé par un signal de commande CMD1, est disposé entre la première portion 41 et la première ligne d'alimentation LVDD1, tandis qu'un autre élément interrupteur, commandé par un signal de commande CMD2, est agencé entre la deuxième portion 42 et la deuxième ligne d'alimentation LVDD2.

Les éléments interrupteurs sont par exemple des transistors 44, 45 dont les grilles respectives reçoivent respectivement le premier signal de commande CMD1 et le deuxième signal de commande CMD2. Un changement d'état du premier signal de commande CMD1 permet de connecter la première portion 41 à la première ligne d'alimentation LVDD1 (initialisation des valeurs pré-chargées), la première ligne d'alimentation LVDD1 recevant la tension d'alimentation VDD. Puis (deuxième phase), un changement d'état du deuxième signal de commande CMD2 retardé selon un retard prédéterminé par rapport au premier signal de commande CMD1 permet de connecter la deuxième portion 42 à la première ligne d'alimentation LVDD2, la première ligne d'alimentation LVDD1 et la deuxième ligne d'alimentation recevant alors toutes les deux la tension d'alimentation VDD.

Un deuxième exemple de circuit 50 permettant d'effectuer une mise sous tension décalée entre les deux lignes d'alimentation LVDD1, LVDD2 est illustré sur la figure 5.

Entre une portion 51 de circuit connectée à un nœud apte à recevoir une tension d'alimentation VDD et la première ligne d'alimentation LVDD1, on prévoit un ou plusieurs tampons (« buffer selon la terminologie-anglo-saxonne) également appelés amplificateurs séparateurs. Entre une autre portion 54 apte à recevoir la tension d'alimentation VDD et la deuxième ligne d'alimentation LVDD2, on dispose également un ou plusieurs tampons 55a, 55b, 55c, 55d.

On prévoit de préférence le gain global en courant du ou des tampons 55a, 55b, 55c, 55d prévus entre la portion 54 et la deuxième ligne d'alimentation LVDD2, inférieur au gain global du ou des tampons 54a, 54b, 54c, 54d afin d'induire un retard de transmission de VDD sur la ligne d'alimentation LVDD2 plus important par rapport au retard induit par les tampons 54a, 54b, 54c, 54d pour transmettre VDD sur la ligne d'alimentation LVDD1.

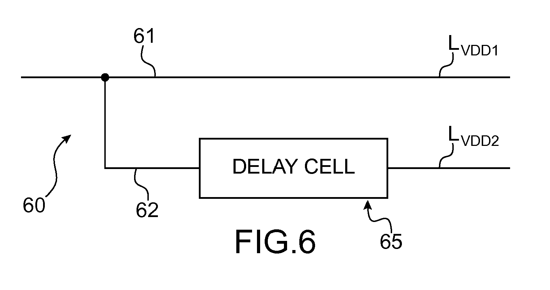

Un troisième exemple de circuit 60 permettant une mise sous tension retardée entre la première ligne d'alimentation LVDD1 et la deuxième ligne d'alimentation LVDD2 est représenté de manière schématique sur la figure 6.

Ce circuit comprend une première portion 61 connectée à la première ligne d'alimentation LVDD1 et à un nœud apte à recevoir la tension d'alimentation VDD. Une cellule à retard 65 est disposée entre une deuxième portion 62 du circuit connectée audit nœud et la deuxième ligne d'alimentation LVDD2.

Les lignes d'alimentation LVDD1 et LVDD2 sont typiquement partagées par des cellules d'une même colonne de cellules, c'est-à-dire de cellules partageant également typiquement une même paire de lignes de bits BL_{T} et BL_{F}.

Pour mettre en œuvre une polarisation ou alimentation dissociée des transistors TL_{T} et TL_{F}, on prévoit les lignes d'alimentation LVDD1 et LVDD2 typiquement sous forme de lignes métalliques distinctes et qui s'étendent dans un niveau métallique d'interconnexions situé au-dessus des transistors.

Les transistors de charge TL_{T} et TL_{F} sont connectés respectivement à l'une des deux lignes d'alimentation LVDD1 et LVDD2 et à l'autre des deux lignes d'alimentation par l'intermédiaire d'éléments conducteurs de type vias.

Pour une cellule mémoire donnée, le placement des vias permettant d'établir une connexion entre les transistors TL_{T} et TL_{F} respectivement à l'une ou l'autre des lignes d'alimentation LVDD1 ou LVDD2 détermine la valeur de la donnée que l'on souhaite pré-charger dans cette cellule.

Ainsi, la cellule Ci décrite précédemment, a des transistors TL_{T}, TL_{F} dont les connexions aux lignes d'alimentation LVDD1, LVDD2 sont agencées différemment de celles des transistors TL_{T}, TL_{F} de la cellule Cₖ ce qui permet de stocker des données différentes entre la cellule Cᵢ et la cellule Cₖ.

Les figures 7A-7D servent à illustrer un exemple de réalisation particulier dans lequel on peut prévoir de réaliser les lignes d'alimentation LVDD1, LVDD2 à partir d'un 2^{ème} niveau métallique encore appelé « métal 2 ». Différentes configurations possibles des vias 71a, 71b, 72a, 72b, qui s'étendent entre un premier niveau de métal et le deuxième niveau sont donnés sur ces figures, un premier transistor de charge pouvant être connecté soit à la première ligne d'alimentation par l'intermédiaire d'un via 71a ou bien à la deuxième ligne d'alimentation par l'intermédiaire d'un via 72a, tandis que l'autre transistor de charge peut être connecté soit à la première ligne d'alimentation par l'intermédiaire d'un via 71b ou bien à la deuxième ligne d'alimentation par l'intermédiaire d'un via 72b.

Un tel agencement ne s'accorde toutefois pas avec toutes les technologies de fabrication.

Ainsi, un autre type d'agencement, davantage compatible avec des technologies de fabrication conventionnelles, est proposé dans l'exemple de réalisation illustré sur les figures 8A-8B, avec des lignes d'alimentation LVDD1, LVDD2 qui s'étendent dans un niveau métallique plus élevé par exemple dans un troisième niveau et un quatrième niveau métallique comportant par exemple quatre niveaux métalliques.

Sur ces figure un ensemble de 8 cellules mémoires élémentaires C₁ₘ, C₂ₘ, C₃ₘ, C₄ₘ, C₅ₘ, C₆ₘ C₇ₘ, C₈ₘ voisines et appartenant de lignes (rangées horizontales) différentes et appartenant à une même colonne m de cellules sont représentées.

Les cellules C₁ₘ, C₂ₘ, C₃ₘ, C₄ₘ, C₅ₘ, C₆ₘ C₇ₘ, C₈ₘ sont ainsi adressées typiquement par des lignes de mots différentes mais sont reliées à une même paire de lignes de bits.

Dans cet exemple, un agencement particulier des connexions aux lignes d'alimentation LVDD1 et LVDD2 est également prévu, chaque cellule partageant une zone de connexion 81 ou 82 commune à une des lignes d'alimentation LVDD1 et LVDD2 avec une cellule voisine d'une rangée horizontale supérieure, et une autre zone de connexion commune 81 ou 82 à une ligne parmi les lignes d'alimentation LVDD1 et LVDD2 avec une autre cellule voisine d'une rangée horizontale inférieure. Un tel agencement permet de réduire l'encombrement des lignes métalliques et vias associés.

Dans cet exemple particulier, les cellules C₁ₘ, C₃ₘ, C₅ₘ, C₇ₘ, de rangées horizontales impaires sont munies d'une zone de connexion 81 à la première ligne d'alimentation LVDD1 et d'une autre zone de connexion 82 à la deuxième d'alimentation ligne LVDD2. Les cellules C₂ₘ, C₄ₘ, C₆ₘ, C₈ₘ, de rangées horizontales paires sont munies soit de deux zones de connexion 81 ou 82 à la même ligne d'alimentation LVDD1 ou LVDD2 soit deux zones de connexion 81, 82 connectées à des lignes d'alimentation LVDD1, LVDD2 distinctes. Avec un tel agencement, les cellules C₁ₘ, C₃ₘ, C₅ₘ, C₇ₘ, des rangées impaires sont aptes à être pré-chargées pendant la première phase résultant de la mise sous tension de la mémoire. Les cellules C₁ₘ, C₃ₘ, C₅ₘ, C₇ₘ sont susceptibles de former une mémoire ROM dont les données correspondent aux valeurs pré-chargées lors de la première phase évoquée précédemment.

Comme cela a été suggéré précédemment, les données pré-chargées par les cellules C₁ₘ, C₃ₘ, C₅ₘ, C₇ₘ dépendent des agencements respectifs des connexions de leurs inverseurs à la ligne d'alimentation LVDD1 et à l'autre ligne d'alimentation LVDD2.

Les cellules C₁ₘ, C₇ₘ ont des agencements semblables l'une par rapport à l'autre de leurs connexions 81, 82 respectivement entre leur premier inverseur et la première ligne d'alimentation LVDD1 et entre leur deuxième inverseur et la deuxième ligne d'alimentation LVDD2. Ces cellules C₁ₘ, C₇ₘ permettent ainsi de stocker une même donnée logique, par exemple un '1' à leur premier nœud T ou un '0' à leur nœud F complémentaire.

Les cellules C₃ₘ, C₅ₘ ont des agencements de leurs zones de connexions 81, 82 différents de celui des cellules C₁ₘ, C₇ₘ, mais semblables entre elles. Ainsi leurs connexions 82, 81 sont cette fois respectivement entre leur premier inverseur et la première ligne d'alimentation LVDD1 et entre leur deuxième inverseur et la deuxième ligne d'alimentation LVDD2. Ces cellules C₃ₘ, C₅ₘ permettent de stocker une même donnée logique par exemple un '0' à leur premier nœud T (ou un '1' à leur deuxième nœud F complémentaire).

Dans l'exemple illustré, les cellules C₂ₘ, C₆ₘ sont dans un état métastable durant la première phase de polarisation des lignes LVDD1 et LVDD2 du fait de leur connexion à une même ligne d'alimentation, tandis que les connexions respectives des cellules C₃ₘ, C₇ₘ imposent par exemple une donnée logique par exemple un '0' au premier nœud T de la cellule C₃ₘ et une donnée logique par exemple un '1' au premier nœud T de la cellule C₇ₘ. Les cellules C₂ₘ, C₄ₘ, C₆ₘ, C₈ₘ, ne sont toutefois pas utilisées comme cellules de mémoire ROM durant le fonctionnement où l'on souhaite accéder aux données de la mémoire ROM. Du fait qu'elles partagent une zone de connexion commune avec leurs cellules voisines respectives, ces cellules C₂ₘ, C₄ₘ, C₆ₘ, C₈ₘ sont donc lors de la séquence d'initialisation, dans un état imposé par celui de leur cellules voisines respectives, les cellules C₂ₘ, C₄ₘ, C₆ₘ, C₈ₘ, et ne feront pas l'objet d'un accès en lecture lors d'une phase dite « d'amorçage » (boot) du circuit, durant laquelle on vient lire les données pré-chargées.

On a donc un dispositif mémoire dont on utilise une ligne (rangée horizontale) sur deux pendant un amorçage (boot) du circuit. En variante, on peut prévoir un agencement dans lequel on n'accède qu'aux cellules de rangées paires.

Ensuite, pendant la deuxième phase, les lignes d'alimentation LVDD1 et LVDD2 sont mises au même potentiel et l'ensemble des cellules C₁ₘ, C₃ₘ, C₅ₘ, C₇ₘ, C₂ₘ, C₄ₘ, C₆ₘ, C₈ₘ retrouve une polarisation, avec une alimentation équilibrée des deux côtés de chaque cellule leur permettant de fonctionner comme une SRAM conventionnelle.

On a donc un dispositif mémoire dont on est susceptible d'utiliser toutes les lignes (rangées horizontales) une fois que les données de mémoire ROM pré-chargées lors de l'initialisation ont été lues.

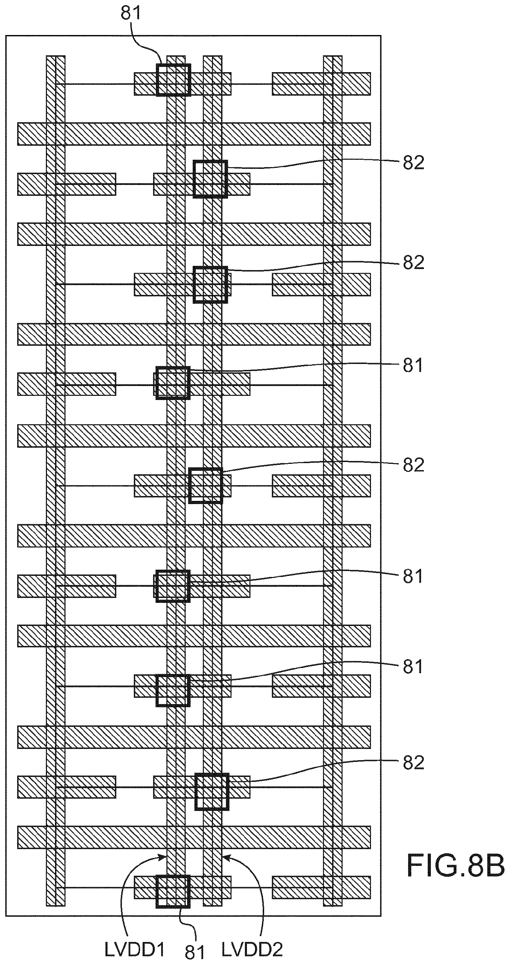

Il convient de noter que dans cette configuration, étant donné que deux cellules mémoires voisines (par exemple C₁ₘ, C₂ₘ) partagent une zone de connexion commune à l'une des première et deuxième lignes d'alimentation (zone 82 couplée à LVDD2), il est possible de choisir la valeur de pré-charge qui sera imposée à l'une des deux cellules mémoires voisines (par exemple C₁ₘ) en choisissant la ligne d'alimentation (LVDD1 sur la figure 8B) qui sera couplée au premier transistor du premier inverseur de cette cellule, l'autre ligne d'alimentation se retrouvant couplée au deuxième transistor du deuxième inverseur. Pour l'autre des deux cellules mémoires voisines (par exemple C₂ₘ), le premier transistor du premier inverseur et le deuxième transistor du deuxième inverseur de cette autre des deux cellules mémoires voisines sont couplés tous les deux à la ligne d'alimentation qui est couplée à la zone de connexion commune (comme c'est le cas pour la cellule C₂ₘ représentée sur la figure 8B), ce qui signifie que la valeur de pré-charge ne peut pas être imposée pour cette autre des deux cellules mémoires voisines.

En variante, il serait possible que le premier transistor du premier inverseur et le deuxième transistor du deuxième inverseur de cette autre des deux cellules mémoires voisines sont couplés aux deux lignes d'alimentation de manière opposée à ladite une des deux cellules mémoires voisines (la zone de connexion 82 commune aux cellules C₂ₘ et C₃ₘ serait couplée à LVDD1), ce qui signifie que la valeur de pré-charge imposée pour la cellule C₂ₘ n'est pas choisie indépendamment de celle choisie pour ladite une des deux cellules mémoires voisines.

La figure 9A illustre de manière schématique une mémoire physique 90 qui comporte un secteur 92 de cellules mémoires réalisant une mémoire RAM avec une ligne sur deux pré-chargée avec un code d'amorçage.

Le secteur 92 est par exemple formé d'un ensemble de cellules telles que mises en œuvre suivant l'invention et ayant un agencement du type de celui décrit précédemment en particulier en lien avec les figures 8A-8B. Ainsi, dans ce secteur 92 une rangée horizontale (ligne) de cellules sur deux, par exemple les rangées horizontales paires (ou les rangées horizontales impaires), comporte des cellules pré-chargées dont on peut se servir comme mémoire ROM pendant une phase dite d'amorçage puis comme, tandis que les cellules des rangées impaires (ou respectivement les cellules des rangées paires) contiennent des valeurs imposées par les cellules voisines dont on ne se sert pas lors de la phase d'amorçage.

Sur cette figure 9A, le bloc 95 représente un ensemble d'adresses virtuelles vues d'un processeur ou d'une unité centrale de traitement, (en anglais CPU pour « central processing unit ») amené à exploiter des données de la mémoire physique 90 et appartenant à un système de traitement numérique.

Le processeur peut être amené, lors d'un premier accès mémoire, correspondant par exemple à une phase de démarrage ou d'amorçage du système, à exploiter ou lire des données de programme, en particulier d'un programme d'amorçage (BOOT selon la terminologie anglo-saxonne) stockées dans la mémoire physique 90 et correspondant à des cellules du secteur 92. Ainsi, on est susceptible d'accéder par exemple aux cellules C₁ₘ, C₃ₘ, C₅ₘ, C₇ₘ des figures 8A-8B.

Le processeur peut être amené ensuite, lors d'un deuxième accès mémoire, à exploiter des données de mémoire RAM, stockées dans le secteur 92. Des cellules du secteur 92 de la mémoire physique 90, qui ont été lues lors du premier accès sont ainsi susceptibles également d'être lues et réécrites lors du deuxième accès. Si l'on se rapporte à l'exemple d'agencement décrit précédemment en lien avec les figures 8A-8B, les cellules C₁ₘ, C₃ₘ, C₅ₘ, C₇ₘ peuvent être lues lors d'un accès à la mémoire ROM puis lors d'un accès à la mémoire RAM.

Dans l'exemple de réalisation de la figure 9B, la mémoire physique comporte, outre le secteur 92, un autre secteur 94 composé de cellules SRAM au fonctionnement conventionnel. Le secteur 94 est formé de cellules qui fonctionnent comme une des cellules SRAM de type conventionnel. Le secteur 94 est par exemple formé de cellules ayant un agencement du type de la cellule C₂ₘ décrite précédemment en lien avec les figures 8A-8B, ou bien un agencement des transistors qui diffère de celui des cellules des figures 1A-1B, 2A-2B, en ce que ses transistors de charge TL_{T}, TL_{F} sont tous les deux connectées à une même ligne d'alimentation, par exemple LVDD1 ou LVVD2.

Le processeur peut être amené, lors d'un premier accès mémoire, correspondant par exemple à une phase de démarrage ou d'amorçage du système, à exploiter ou lire des données de programme, correspondant à des cellules du secteur 92.

Le processeur peut être amené ensuite, lors d'un deuxième accès mémoire, à exploiter des données de mémoire RAM, stockées soit dans le secteur 92 soit dans le secteur 94.

Une différenciation entre un accès à la mémoire ROM et un accès à la mémoire RAM est réalisé par décodage d'adresse virtuelle lors de la réception d'une requête d'accès en lecture/écriture. Cette différenciation entre accès à la mémoire ROM et accès à la mémoire RAM est opéré à l'aide d'un module de gestion d'adresses virtuelles permettant de convertir une adresse virtuelle en adresse physique.

Lorsque le module de gestion d'adresses virtuelle détecte qu'un accès à la mémoire RAM est requis, il applique un type d'opération donné à une adresse virtuelle pour produire une adresse physique correspondant à l'un des deux secteurs 92, 94. Ce type d'opération peut comprendre une opération de soustraction d'une valeur de décalage (« offset » selon la terminologie anglo-saxonne) de l'adresse virtuelle.

Lorsqu'un accès à la mémoire ROM est requis, un type d'opération différent est mis en œuvre, dans la mesure où celle-ci n'occupe pas toutes les lignes (rangées horizontales) du secteur 92. Ce type d'opération peut comprendre une opération de soustraction d'une autre valeur de décalage (offset) ainsi qu'un déplacement (shift), afin de produire une adresse physique correspondant par exemple uniquement à une ligne paire ou impaire de la mémoire physique 90.

Lorsque ce sont des lignes ou rangées horizontales impaires de la mémoire physique qui remplissent la fonction de mémoire ROM, un déplacement de 1 à gauche et une insertion de '1' peut permettre par exemple de produire une adresse physique correspondant à une ligne impaire.

En variante, lorsque la mémoire ROM est réalisée par des lignes ou rangées horizontales paires, un déplacement de 1 à gauche et une insertion de '0' peut permettre par exemple de produire une adresse physique correspondant à une ligne paire.

Différents exemples de mise en œuvre d'un module 100 de conversion d'adresse virtuelle en adresse physique sont donnés sur les figures 10A-10C.

Ces figures servent à illustrer respectivement :
- un premier cas dans lequel le module 100 est entièrement dissocié d'un support 98 sur lequel se trouve la mémoire physique 90,
- un deuxième cas dans lequel le module 100 est partiellement situé sur le support 98 de la mémoire physique 90,
- un troisième cas dans lequel le module 100 est entièrement intégré sur le même support 98 que la mémoire physique 90.

Dans le deuxième cas, le support 98 de mémoire peut comprendre un signal d'entrée spécifique pour recevoir un signal ROM_MODE indicateur d'un type d'accès mémoire réalisé sur la mémoire physique entre un accès à des cellules de cette mémoire accessibles en lecture seule ou à des cellules de cette mémoire accessibles en lecture et écriture.

Dans le troisième cas, le support 98 sur lequel se trouve la mémoire peut comprendre un décodeur 102, ce décodeur 102 disposant alors typiquement d'informations de mappage liées à la mémoire virtuelle 95 vue du processeur.

Dans les trois cas, le module 100 est doté d'un décodeur 102 configuré pour à partir d'une adresse virtuelle « VirtualAddr » émettre un signal indicateur ROM_MODE de type d'accès mémoire entre un accès relatif à la mémoire ROM et un accès relatif à la mémoire RAM. Ce signal indicateur est différent suivant qu'un accès à la mémoire ROM ou à la mémoire RAM est requis. Le décodeur 102 peut se servir pour cela d'une donnée « boot_size » liée à la taille de l'espace réservé à la mémoire ROM 97.

Le décodeur 102 est configuré pour transmettre le signal indicateur de type d'accès mémoire et transmettre l'adresse virtuelle à un module de décalage 104 chargé d'appliquer un type d'opération dite de « décalage » à l'adresse virtuelle et produire en conséquence une adresse physique « PhysicalAddr » résultant de cette opération. Le type d'opération effectué par le module de décalage 104 est différent selon que le signal indicateur de type d'accès mémoire reçu par le module de décalage 104 indique un accès à la mémoire ROM ou un accès à la mémoire RAM.

Un exemple d'utilisation d'un tel dispositif dans un système numérique, comportant un processeur, par exemple un processeur graphique ou GPU (pour « Graphics Processing Unit ») ou un processeur de signal numérique (DSP pour « Digital Signal Processor ») est le suivant :
Après mise sous tension du système numérique ou démarrage du système numérique, certaines cellules du secteur 92, en particulier les cellules des rangées paires (ou bien les cellules de rangées impaires), sont pré-chargées par le biais de la première phase de polarisation des lignes LVDD1, LVDD2, et les données de la mémoire ROM (secteur 97 vu par le processeur de la mémoire virtuelle 95) peuvent être accédées en émettant des requêtes comportant des adresses virtuelles, typiquement présentées de manière incrémentale en commençant par une adresse, appelée « boot_address », par exemple 0X0000.

Le décodeur 102 identifie à partir de l'adresse virtuelle le type d'accès mémoire demandé et dans le cas présent détecte un accès à la mémoire ROM. Un signal par exemple par le biais de l'entrée ROM_MODE maintenue au même potentiel indique au module 104 de décalage qu'un accès à la mémoire ROM. Ce module 104 réalise une opération sur l'adresse virtuelle de manière à générer une adresse physique.

Avantageusement, l'opération effectuée est prévue de sorte à ne produire une adresse physique ne donnant accès ou ne correspondant qu'à des rangées impaires de cellules, ou ne donnant accès ou ne correspondant qu'à des rangées paires de cellules. L'opération effectuée est par exemple un décalage de bits vers la gauche et ajout d'un '1' lorsque les cellules mémoires ROM sont celles des rangées impaires du secteur 92 , ou un décalage de bits vers la gauche et un ajout de '0' lorsque les cellules mémoires ROM sont celles des rangées paires du secteur 92.

Les données de la mémoire RAM (secteur 99 vu par le processeur) peuvent être alors accédées en commençant par une adresse, située à boot_address+boot_size (boot_size correspondant à la taille de mémoire ROM) correspondant par exemple à 0X2000.

Le décodeur 102 identifie à partir de l'adresse virtuelle le type d'accès mémoire demandé et dans le cas présent détecte un accès à la mémoire RAM. Un signal par exemple par le biais d'un changement de polarité sur l'entrée ROM_MODE indique au module 104 un accès à la mémoire RAM. Ce module 104 réalise alors une opération, par exemple en effectuant une opération de soustraction de « boot_size » sur l'adresse virtuelle. Cette opération est donc d'un type différent de celui de la première phase. Lors d'un accès au secteur virtuel 99, il n'y a donc pas de décalage, juste une soustraction.

## Revendications

1. Dispositif mémoire doté :
- d'un ensemble de cellules mémoires (C₁ₘ, C₂ₘ, C₃ₘ, C₄ₘ, C₅ₘ, C₆ₘ, C₇ₘ, C₈ₘ, Cᵢ, Cₖ) chaque cellule mémoire dudit ensemble comprenant :
- un premier nœud (T) et un deuxième nœud (F),
- un premier inverseur et un deuxième inverseur connectés de façon croisée entre ledit premier nœud et ledit deuxième nœud,
le dispositif mémoire comprenant en outre :
- une première ligne d'alimentation (LVDD1) connectée à l'un parmi un premier transistor du premier inverseur et un deuxième transistor du deuxième inverseur,
- une deuxième ligne d'alimentation (LVDD2) connectée à l'autre parmi ledit premier transistor du premier inverseur et ledit deuxième transistor du deuxième inverseur, la deuxième ligne d'alimentation étant distincte de la première ligne d'alimentation,
le dispositif mémoire étant doté d'un circuit (40, 50, 60) configuré pour, lors d'une séquence d'initialisation :
- pendant une première phase, appliquer un premier couple de potentiels (VDD1_{high}, VDD2_{low}), respectivement sur la première ligne d'alimentation (LVDD1) et la deuxième ligne d'alimentation (LVDD2), de sorte à imposer à des cellules dudit ensemble, des données logiques de pré-charge dont les valeurs respectives dépendent de la ligne d'alimentation parmi lesdites première et deuxième lignes d'alimentation à laquelle son premier transistor et son deuxième transistor sont respectivement connectées, puis
- pendant une deuxième phase, appliquer un deuxième couple de potentiels (VDD1_{high}, VDD2_{high}) respectivement sur ladite première ligne d'alimentation (LVDD1) et la deuxième ligne d'alimentation (LVDD2), le deuxième couple de potentiels étant différent du premier couple de potentiels et prévu de sorte à maintenir ces données logiques de pré-charge et rendre les cellules dudit ensemble accessibles en lecture et en écriture,
et dans lequel une première cellule mémoire (C₁ₘ) et une deuxième cellule mémoire (C₂ₘ) voisine de la première cellule dans ledit ensemble partagent une première zone de connexion commune à l'une desdites première ligne d'alimentation (LVDD1) ou deuxième ligne d'alimentation (LVDD2) qui est choisie en fonction de la valeur souhaitée de la donnée logique de pré-charge à imposer à l'une des deux cellules mémoires (C₁ₘ, C₂ₘ) voisines dudit ensemble au cours de la première phase de la séquence d'initialisation,
la première cellule (C₁ₘ, Cᵢ) ayant son premier inverseur connecté à la première ligne d'alimentation et son deuxième inverseur connecté à la deuxième ligne d'alimentation,
la deuxième cellule (C₂ₘ, Cₖ) ayant ses deux inverseurs connectés à une même ligne d'alimentation donnée parmi lesdites première ligne d'alimentation (LVDD1) et deuxième ligne d'alimentation (LVDD2) ou ayant son premier inverseur connecté à la deuxième ligne d'alimentation et son deuxième inverseur connecté à la première ligne d'alimentation.

2. Dispositif mémoire selon la revendication 1, dans lequel ledit ensemble de cellules comporte au moins une troisième cellule (C₃ₘ) située sur une même colonne de cellules que la première cellule (C₁ₘ) et la deuxième cellule (C₂ₘ) de sorte que la deuxième cellule est située entre la première cellule et la troisième cellule, la troisième cellule ayant un de ses inverseurs connecté à la première ligne d'alimentation (LVDD1) et un autre de ses inverseurs connecté à la deuxième ligne d'alimentation (LVDD2).

3. Dispositif mémoire selon la revendication 2, dans lequel ladite troisième cellule (C₃ₘ) est voisine de la deuxième cellule (C₂ₘ) et partage avec la deuxième cellule une deuxième zone de connexion commune (82), la deuxième cellule étant disposée entre le première cellule et la troisième cellule, la deuxième zone de connexion commune étant connectée à la première ligne d'alimentation lorsque la première zone de connexion commune est connectée à la première ligne d'alimentation ou, la deuxième zone de connexion commune étant connectée à la deuxième ligne d'alimentation lorsque la première zone de connexion commune est connectée à la deuxième ligne d'alimentation.

4. Dispositif mémoire selon la revendication 3, dans lequel la première zone de connexion commune et la deuxième zone de connexion commune sont connectées à la première ligne d'alimentation, ledit ensemble étant doté d'au moins une quatrième cellule disposée sur une même colonne de cellules que la première cellule, la deuxième cellule et la troisième cellule, la quatrième cellule ayant des inverseurs connectées à la deuxième ligne d'alimentation.

5. Dispositif mémoire selon l'une des revendications 1 à 4, dans lequel ledit ensemble de cellules est un premier ensemble situé dans un premier secteur (92) d'un plan matriciel de cellules, ledit plan matriciel comprenant un deuxième secteur (94) doté d'un deuxième ensemble de cellules mémoires, lesdites cellules dudit deuxième secteur (94) étant des cellules SRAM dotées d'inverseurs connectées à une même ligne d'alimentation ou recevant un même potentiel d'alimentation pendant la première phase et pendant la deuxième phase de la séquence d'initialisation.

6. Dispositif mémoire selon l'une des revendications 1 à 5, dans lequel ledit ensemble appartient à un plan matriciel agencé en colonnes et en rangées horizontales alternativement paires et impaires de cellules,
- dans lequel la première cellule (C1m) mémoire appartient à une rangée horizontale impaire de cellules et dans lequel ladite autre cellule (C₂ₘ, Cₖ) dudit ensemble a ses deux inverseurs connectés à une même ligne d'alimentation donnée parmi lesdites première ligne d'alimentation (LVDD1) et deuxième ligne d'alimentation (LVDD2) et appartient à une rangées paire de cellules, ou
- dans lequel la première cellule (C1m) mémoire appartient à une rangée horizontale paire de cellules, et dans lequel ladite autre cellule (C₂ₘ, Cₖ) dudit ensemble a ses deux inverseurs connectés à une même ligne d'alimentation donnée parmi lesdites première ligne d'alimentation (LVDD1) et deuxième ligne d'alimentation (LVDD2) et appartient à une rangées impaire de cellules.

7. Dispositif mémoire selon l'une des revendications 1 à 6, comprenant en outre un module de conversion d'adresse mémoire virtuelle en adresse mémoire physique, ledit module de conversion (100) étant doté d'un module de décalage (104) configuré pour, consécutivement à ladite séquence d'initialisation :
- détecter un signal indicateur d'un premier type d'accès mémoire relatif à un accès à des cellules mémoires accessibles en lecture seule dudit ensemble, et à appliquer en conséquence un premier type d'opération à une adresse virtuelle afin de produire une adresse physique, puis,
- détecter un signal indicateur d'un deuxième type d'accès mémoire, relatif à un accès à des cellules mémoires accessibles en lecture et en écriture dudit ensemble, et à appliquer en conséquence un deuxième type d'opération de décalage à une adresse virtuelle afin de produire une adresse physique, le deuxième type d'opération étant différent dudit premier type d'opération.

8. Dispositif mémoire selon la revendication 7, dans lequel le premier type d'opération est prévu de sorte à restreindre l'accès uniquement à des rangées horizontales paires parmi lesdites rangées horizontales dudit ensemble de cellules ou à restreindre l'accès uniquement à des rangées horizontale impaires parmi lesdites rangées horizontales dudit ensemble de cellules, dans lequel le deuxième type d'opération est susceptible de donner accès à l'intégralité des rangées horizontales dudit ensemble de cellules.

9. Dispositif mémoire selon la revendication 7 ou 8, dans lequel le module de conversion comporte un décodeur (102) configuré pour :
- à partir d'une adresse virtuelle, produire un signal indicateur d'un premier type d'accès mémoire relatif ou un signal indicateur d'un deuxième type d'accès mémoire,
- transmettre cette adresse virtuelle au module de décalage,
ledit ensemble de cellules, ledit module de décalage, et avantageusement le décodeur étant disposés sur un même support.

10. Dispositif mémoire selon l'une des revendications 1 à 9, dans lequel la première phase est consécutive à une mise sous tension du dispositif mémoire, ledit circuit étant configuré pour :
- pendant la première phase appliquer le premier couple de potentiels en mettant sous tension la première ligne d'alimentation (LVDD1), en particulier de sorte à lui appliquer une tension d'alimentation VDD sans alimenter la deuxième ligne d'alimentation (LVDD2), puis, après un retard prédéterminé,
- pendant la deuxième phase appliquer le deuxième couple de potentiels en maintenant sous tension la première ligne d'alimentation (LVDD1) tout en mettant sous tension la deuxième ligne d'alimentation (LVDD2), de préférence à la même tension d'alimentation VDD.

11. Dispositif mémoire selon la revendication 10, dans lequel ledit circuit (40) comprend :
- une première portion (41) et une deuxième portion (42) de circuit recevant chacune une tension d'alimentation VDD,
- un premier élément interrupteur (44) entre la première portion et la première ligne d'alimentation (LVDD1), apte à alternativement déconnecter puis connecter la première portion de circuit à la première ligne d'alimentation (LVDD1) suite à un changement d'état d'un premier signal de commande (CMD1),
- un deuxième élément interrupteur (45) entre la deuxième portion et la deuxième ligne d'alimentation (LVDD2), apte à alternativement déconnecter puis connecter la deuxième portion de circuit à la deuxième ligne d'alimentation (LVDD2) suite à un changement d'état d'un deuxième signal de commande (CMD2), le changement d'état du deuxième signal de commande (CMD2) étant retardé par rapport au changement d'état du premier signal de commande (CMD1) selon ledit retard prédéterminé.

12. Dispositif mémoire selon la revendication 10, dans lequel ledit circuit (50) comprend :
- une première portion (51) et une deuxième portion (52) recevant chacune une tension d'alimentation VDD,
- au moins un premier tampon (54a, 54b, 54c, 54d) entre la première portion (51) et la première ligne d'alimentation (LVDD1),
- au moins un deuxième tampon (55a, 55b, 55c, 55d) entre la deuxième portion (52) et la deuxième ligne d'alimentation (LVDD2), ledit premier tampon ayant un gain en courant différent de celui du deuxième tampon.

13. Dispositif mémoire selon la revendication 10, ledit circuit (60) comprenant :
- une première portion (61) connectée à la première ligne d'alimentation (LVDD1) et à un nœud (60) recevant une tension d'alimentation VDD,
- une deuxième portion (62) connectée audit nœud (60), au moins une cellule à retard étant disposée entre la deuxième portion (62) et la deuxième ligne d'alimentation (LVDD2).

## Patentansprüche

1. Speichervorrichtung, ausgestattet mit:
- eine Menge von Speicherzellen (C₁ₘ, C₂ₘ, C₃ₘ, C₄ₘ, C₅ₘ, C₆ₘ, C₇ₘ, C₈ₘ, Cᵢ, Cₖ), wobei jedes Speicherzelle der Menge umfasst:
- einen ersten Knoten (T) und einen zweiten Knoten (F),
- einen ersten Umschalter und einen zweiten Umschalter, die gekreuzt zwischen dem ersten Knoten und dem zweiten Knoten verbunden sind,
wobei die Speichervorrichtung weiterhin umfasst:
- eine erste Versorgungsleitung (LVDD1), die mit einem von einem ersten Transistor des ersten Umschalters und einem zweiten Transistor des zweiten Umschalters verbunden ist,
- einer zweite Versorgungsleitung (LVDD2), die mit dem anderen von dem ersten Transistor des ersten Umschalters und dem zweiten Transistor des zweiten Umschalters verbunden ist, wobei die zweite Versorgungsleitung sich von der ersten Versorgungsleitung unterscheidet,
wobei die Speichervorrichtung mit einem Schaltkreis (40, 50, 60) ausgestattet ist, der konfiguriert ist zum, während einer Initialisierungssequenz:
- während einer ersten Phase Anwenden eines ersten Paars von Potentialen (VDD1_{hoch}, VDD2_{niedrig}) auf die erste Versorgungsleitung (LVDD1) bzw. die zweite Versorgungsleitung (LVDD2), so dass Zellen der Menge logische Vorladedaten auferlegt werden, deren jeweiligen Werte von der Versorgungsleitung von der ersten und der zweiten Versorgungsleitung, mit denen ihr erster Transistor und ihr zweiter Transistor jeweils verbunden sind, abhängen, dann
- während einer zweiten Phase Anwenden eines zweiten Paars von Potentialen (VDD1_{hoch}, VDD2_{hoch}) auf die erste Versorgungsleitung (LVDD1) bzw. die zweite Versorgungsleitung (LVDD2), wobei das zweite Paar von Potentialen sich von dem ersten Paar von Potentialen unterscheidet und dazu vorgesehen ist, diese logischen Vorladedaten zu pflegen und die Zellen der Menge für Lese- und Schreibvorgänge zugänglich zu machen,
und wobei eine erste Speicherzelle (C₁ₘ) und eine zweite Speicherzelle (C₂ₘ) benachbart zu der ersten Zelle in der Menge eine erste gemeinsame Verbindungszone gemeinsam mit der einen von der ersten Versorgungsleitung (LVDD1) und der zweiten Versorgungsleitung (LVDD2) nutzen, die in Abhängigkeit von dem gewünschten Wert der logischen Vorladedaten zum Auferlegen auf die eine von zwei benachbarten Speicherzellen (C₁ₘ, C₂ₘ) der Menge im Verlauf der ersten Phase der Initialisierungssequenz gewählt wird,
wobei die erste Zelle (C₁ₘ, Cᵢ) ihren ersten Umschalter mit der ersten Versorgungsleitung verbunden und ihren zweiten Umschalter mit der zweiten Versorgungsleitung verbunden aufweist,
wobei die zweite Zelle (C₂ₘ, Cₖ) ihre zwei Umschalter mit derselben gegebenen Versorgungsleitung von der ersten Versorgungsleitung (LVDD1) und der zweiten Versorgungsleitung (LVDD2) verbunden aufweist oder ihren ersten Umschalter mit der zweiten Versorgungsleitung verbunden und ihren zweiten Umschalter mit der ersten Versorgungsleitung verbunden aufweist.

2. Speichervorrichtung nach Anspruch 1, wobei die Menge von Zellen mindestens eine dritte Zelle (C₃ₘ) umfasst, die sich auf derselben Spalte von Zellen wie die erste Zelle (C₁ₘ) und die zweite Zelle (C₂ₘ) befindet, so dass die zweite Zelle sich zwischen der ersten Zelle und der dritten Zelle befindet, wobei die dritte Zelle einen ihrer Umschalter mit der ersten Versorgungsleitung (LVDD1) verbunden und einen anderen ihrer Umschalter mit der zweiten Versorgungsleitung (LVDD2) verbunden aufweist.

3. Speichervorrichtung nach Anspruch 2, wobei die dritte Zelle (C₃ₘ) zu der zweiten Zelle (C₂ₘ) benachbart ist und mit der zweiten Zelle eine zweite gemeinsame Verbindungszone (82) gemeinsam nutzt, wobei die zweite Zelle zwischen der ersten Zelle und der dritten Zelle angeordnet ist, wobei die zweite gemeinsame Verbindungszone mit der ersten Versorgungsleitung verbunden ist, wenn die erste gemeinsame Verbindungszone mit der ersten Versorgungsleitung verbunden ist, oder die zweite gemeinsame Verbindungszone mit der zweiten Versorgungsleitung verbunden ist, wenn die erste gemeinsame Verbindungszone mit der zweiten Versorgungsleitung verbunden ist.

4. Speichervorrichtung nach Anspruch 3, wobei die erste gemeinsame Verbindungszone und die zweite gemeinsame Verbindungszone mit der ersten Versorgungsleitung verbunden sind, wobei die Menge mit mindestens einer vierten Zelle ausgestattet ist, die auf derselben Spalte von Zellen wie die erste Zelle, die zweite Zelle und die dritte Zelle angeordnet ist, wobei die vierte Zelle Umschalter aufweist, die mit der zweiten Versorgungsleitung verbunden sind.

5. Speichervorrichtung nach einem der Ansprüche 1 bis 4, wobei die Menge von Zellen eine erste Menge ist, die sich in einem ersten Bereich (92) einer Matrixebene von Zellen befindet, wobei die Matrixebene einen zweiten Bereich (94) umfasst, der mit einer zweiten Menge von Speicherzellen ausgestattet ist, wobei die Zellen des zweiten Bereichs (94) SRAM-Zellen sind, die mit Umschaltern ausgestattet sind, die mit derselben Versorgungsleitung verbunden sind oder dasselbe Versorgungspotential während der ersten Phase und während der zweiten Phase der Initialisierungssequenz empfangen.

6. Speichervorrichtung nach einem der Ansprüche 1 bis 5, wobei die Menge zu einer Matrixebene gehört, die in Spalten und in abwechselnd geraden und ungeraden horizontalen Zeilen von Zellen eingerichtet ist,
- wobei die erste Speicherzelle (C1m) zu einer ungeraden horizontalen Zeile von Zellen gehört und wobei die andere Zelle (C₂ₘ, Cₖ) der Menge ihre zwei Umschalter mit derselben gegebenen Versorgungsleitung von der ersten Versorgungsleitung (LVDD1) und der zweiten Versorgungsleitung (LVDD2) verbunden aufweist und zu einer geraden Zeile von Zellen gehört, oder
- wobei die erste Speicherzelle (C1m) zu einer geraden horizontalen Zeile von Zellen gehört und wobei die andere Zelle (C₂ₘ, Cₖ) der Menge ihre zwei Umschalter mit derselben gegebenen Versorgungsleitung von der ersten Versorgungsleitung (LVDD1) und der zweiten Versorgungsleitung (LVDD2) verbunden aufweist und zu einer ungeraden Zeile von Zellen gehört.

7. Speichervorrichtung nach einem der Ansprüche 1 bis 6, weiterhin umfassend ein Modul zur Umwandlung einer virtuellen Speicheradresse in eine physikalische Speicheradresse, wobei das Umwandlungsmodul (100) mit einem Verschiebungsmodul (104) ausgestattet ist, das konfiguriert ist zum, nach der Initialisierungssequenz:
- Erfassen eines Anzeigesignals eines ersten relativen Speicherzugangstyps eines Zugangs zu nur für Lesevorgänge zugänglichen Speicherzellen der Menge und dementsprechend Anwenden eines ersten Betriebstyps auf eine virtuelle Adresse, um eine physikalische Adresse zu produzieren, dann
- Erfassen eines Anzeigesignals eines zweiten relativen Speicherzugangstyps eines Zugangs zu für Lese- und Schreibvorgänge zugänglichen Speicherzellen der Menge und dementsprechend Anwenden eines zweiten Verschiebungsbetriebstyps auf eine virtuelle Adresse, um eine physikalische Adresse zu produzieren, wobei der zweite Betriebstyp sich von dem ersten Betriebstyp unterscheidet.

8. Speichervorrichtung nach Anspruch 7, wobei der erste Betriebstyp dazu vorgesehen ist, den Zugang einzig zu geraden horizontalen Zeilen von den horizontalen Zeilen der Menge von Zellen zu beschränken oder den Zugang einzig zu ungeraden horizontalen Zeilen von den horizontalen Zeilen der Menge von Zellen zu beschränken, wobei der zweite Betriebstyp dazu fähig ist, Zugang zu der Gesamtheit von horizontalen Zeilen der Menge von Zellen zu gewähren.

9. Speichervorrichtung nach Anspruch 7 oder 8, wobei das Umwandlungsmodul einen Decoder (102) umfasst, der konfiguriert ist zum:
- aus einer virtuellen Adresse Produzieren eines Anzeigesignals eines ersten relativen Speicherzugangstyps oder eines Anzeigesignals eines zweiten Speicherzugangstyps,
- Übertragen dieser virtuellen Adresse an das Verschiebungsmodul,
wobei die Menge von Zellen, das Verschiebungsmodul und vorteilhafterweise der Decoder auf demselben Träger angeordnet sind.

10. Speichervorrichtung nach einem der Ansprüche 1 bis 9, wobei die erste Phase auf ein Hochfahren der Speichervorrichtung folgt, wobei die Schaltung konfiguriert ist zum:
- während der ersten Phase Anwenden des ersten Paars von Potentialen durch Hochfahren der ersten Versorgungsleitung (LVDD1), insbesondere so dass eine Versorgungsspannung VDD darauf angewendet wird, ohne dass die zweite Versorgungsleitung (LVDD2) versorgt wird, dann nach einer vorherbestimmten Verzögerung
- während der zweiten Phase Anwenden des zweiten Paars von Potentialen durch Aufrechterhalten der Spannung der ersten Versorgungsleitung (LVDD1), während die zweite Versorgungsleitung (LVDD2) vorzugsweise mit derselben Versorgungsspannung VDD hochgefahren wird.

11. Speichervorrichtung nach Anspruch 10, wobei die Schaltung (40) umfasst:
- einen ersten Abschnitt (41) und einen zweiten Abschnitt (42) der Schaltung, die jeweils eine Versorgungsspannung VDD empfangen,
- ein erstes Schalterelement (44) zwischen dem ersten Abschnitt und der ersten Versorgungsleitung (LVDD1), das dazu geeignet ist, den ersten Abschnitt der Schaltung nach einer Veränderung des Zustands eines ersten Steuersignals (CMD1) abwechselnd von der ersten Versorgungsleitung (LVDD1) zu trennen und dann mit dieser zu verbinden,
- ein zweites Schalterelement (45) zwischen dem zweiten Abschnitt und der zweiten Versorgungsleitung (LVDD2), das dazu geeignet ist, den zweiten Abschnitt der Schaltung nach einer Veränderung des Zustands eines zweiten Steuersignals (CMD2) abwechselnd von der zweiten Versorgungsleitung (LVDD2) zu trennen und dann mit dieser zu verbinden, wobei die Veränderung des Zustands des zweiten Steuersignals (CMD2) in Bezug auf die Veränderung des Zustands des ersten Steuersignals (CMD1) gemäß der vorherbestimmten Verzögerung verzögert ist.

12. Speichervorrichtung nach Anspruch 10, wobei die Schaltung (50) umfasst:
- einen ersten Abschnitt (51) und einen zweiten Abschnitt (52), die jeweils eine Versorgungsspannung VDD empfangen,
- mindestens einen ersten Puffer (54a, 54b, 54c, 54d) zwischen dem ersten Abschnitt (51) und der ersten Versorgungsleitung (LVDD1),
- mindestens einen zweiten Puffer (55a, 55b, 55c, 55d) zwischen dem zweiten Abschnitt (52) und der zweiten Versorgungsleitung (LVDD2), wobei der erste Puffer eine Stromverstärkung aufweist, die sich von der des zweiten Puffers unterscheidet.

13. Speichervorrichtung nach Anspruch 10, wobei die Schaltung (60) umfasst:
- einen ersten Abschnitt (61), der mit der ersten Versorgungsleitung (LVDD1) und mit einem Knoten (60) verbunden ist und der eine Versorgungsspannung VDD empfängt,
- einen zweiten Abschnitt (62), der mit dem Knoten (60) verbunden ist, wobei mindestens eine Verzögerungszelle zwischen dem zweiten Abschnitt (62) und der zweiten Versorgungsleitung (LVDD2) angeordnet ist.

## Claims

1. A memory device provided with:
- a set of memory cells (C₁ₘ, C₂ₘ, C₃ₘ, C₄ₘ, C₅ₘ, C₆ₘ, C₇ₘ, C₈ₘ, Cᵢ, Cₖ), each memory cell of said set comprising:
- a first node (T) and a second node (F),
- a first inverter and a second inverter connected in a manner crossed between said first node and said second node,
the memory device further comprising:
- a first supply line (LVDD1) connected to one of a first transistor of the first inverter and a second transistor of the second inverter,
- a second supply line (LVDD2) connected to the other of said first transistor of the first inverter and said second transistor of the second inverter, the second supply line being distinct from the first supply line,
the memory device being provided with a circuit (40, 50, 60) configured for, during an initialisation sequence:
- during a first phase, applying a first pair of potentials (VDD1_{high}, VDD2_{low}), respectively to the first supply line (LVDD1) and the second supply line (LVDD2), so as to impose on the cells of said set, pre-load logic data the respective values of which depend on the supply line of said first and second supply lines to which the first transistor thereof and the second transistor thereof are respectively connected, then
- during a second phase, applying a second pair of potentials (VDD1_{low}, VDD2_{high}) respectively to said first supply line (LVDD1) and the second supply line (LVDD2), the second pair of potentials being different from the first pair of potentials and provided so as to keep said pre-load logic data and make the cells of said set readable and writeable,
and wherein two neighbouring memory cells (C₁ₘ, C₂ₘ) of said set share a first common connection area with one of said first supply line (LVDD1) or second supply line (LVDD2) that is chosen according to the desired value of the pre-load logic data to be imposed on one of the two neighbouring memory cells of said set during the first phase of the initialisation sequence,
first cell (C₁ₘ, Cᵢ) of said set having the first inverter thereof connected to the first supply line and the second inverter thereof connected to the second supply line,
the second cell (C₂ₘ, Cₖ) of said set having the two inverters thereof connected to the same given supply line from said first supply line and second supply line or having the first inverter thereof connected to the second supply line and the second inverter thereof connected to the first supply line.

2. The memory device according to claim 1, wherein said set of cells includes at least one third cell (C₃ₘ) situated on a same column of cells as the first cell (C₁ₘ) and the second cell (C₂ₘ) so that the second cell is situated between the first cell and the third cell, the third cell having one of the inverters thereof connected to the first supply line (LVDD1) and another of the inverters thereof connected to the second supply line (LVDD2).

3. The memory device according to claim 2, wherein said third cell (C₃ₘ) is neighbouring the second cell (C₂ₘ) and shares with the second cell a second common connection area (82), the second cell being disposed between the first cell and the third cell, the second common connection area being connected to the first supply line when the first common connection area is connected to the first supply line or, the second common connection area being connected to the second supply line when the first common connection area is connected to the second supply line.

4. The memory device according to claim 3, wherein the first common connection area and the second common connection area are connected to the first supply line, said set being provided with at least one fourth cell disposed on a same column of cells as the first cell, the second cell and the third cell, the fourth cell having inverters connected to the second supply line.

5. The memory device according to any of the claims 1 to 4, wherein said set of cells is a first set situated in a first sector (92) of a matrix plane of cells, said matrix plane comprising a second sector (94) provided with a second set of memory cells, said cells of said second sector being SRAM cells provided with inverters connected to a same supply line or receiving a same supply potential during the first phase and during the second phase of the initialisation sequence.

6. The memory device according to any of the claims 1 to 5, wherein said set belongs to a matrix plane arranged in columns and in horizontal rows alternately odd and even of cells,
- wherein the first memory cell (C₁ₘ) belongs to an odd horizontal row of cells and wherein said other cell (C₂ₘ, Cₖ) of said set has the two inverters thereof connected to a same given supply line from said first supply line (LVDD1) and second supply line (LVDD2) and belongs to an even row of cells, or
- wherein the first memory cell (C₁ₘ) belongs to an even horizontal row of cells and wherein said other cell (C₂ₘ, Cₖ) of said set has the two inverters thereof connected to a same given supply line (LVDD1) from said first supply line and second supply line (LVDD2) and belongs to an odd row of cells.

7. The memory device according to any of the claims 1 to 6, further comprising a module for converting virtual memory addresses into physical memory addresses, said conversion module (100) being provided with an offset module (104) configured for, following said initialisation sequence:
- detecting an indicator signal of a first type of memory access relative to an access to the read-only memory cells of said set, and to consequently apply a first type of operation to a virtual address in order to produce a physical address, then,
- detecting an indicator signal of a second type of memory access, relative to an access to the readable and writeable memory cells of said set, and to consequently apply a first type of offset operation to a virtual address in order to produce a physical address, the second type of operation being different from said first type of operation.

8. The memory device according to claim 7, wherein the first type of operation is provided so as to restrict the access only to the even horizontal rows from said horizontal rows of said set of cells or to restrict the access only to the odd horizontal rows from said horizontal rows of said set of cells, wherein the second type of operation is able to give access to all of the horizontal rows of said set of cells.

9. The memory device according to claim 7 or 8, wherein the conversion module includes a decoder (102) configured for:
- from a virtual address, producing an indicator signal of a first type of relative memory access or an indicator signal of a second type of memory access,
- transmitting said virtual address to the offset module,
said set of cells, said offset module, and advantageously the decoder being disposed on a same support.

10. The memory device according to any of the claims 1 to 9, wherein the first phase is consecutive to a powering on of the memory device, said circuit being configured for:
- during the first phase, applying the first pair of potentials by powering on the first supply line, in particular so as to apply thereto a supply voltage VDD without supplying the second supply line, then, after a predetermined delay,
- during the second phase, applying the second pair of potentials by keeping powered on the first supply line whilst powering on the second supply line, preferably with the same supply voltage VDD.

11. The memory device according to claim 10, wherein said circuit (40) comprises:
- a first portion (41) and a second circuit portion (42) each receiving a supply voltage VDD,
- a first switch element (44) between the first portion and the first supply line (LVDD1), suitable for alternately disconnecting then connecting the first circuit portion to the first supply line (LVDD1) following a change of state of a first control signal (CMD1),
- a second switch element (45) between the second portion and the second supply line (LVDD2), suitable for alternately disconnecting then connecting the second circuit portion to the second supply line (LVDD2) following a change of state of a second control signal (CMD2), the change of state of the second control signal being delayed in relation to the change of state of the first control signal (CMD1) according to said predetermined delay.

12. The memory device according to claim 10, wherein said circuit (50) comprises:
- a first portion (51) and a second portion (52) each receiving a supply voltage VDD,
- at least one first buffer (54a, 54b, 54c, 54d) between the first portion and the first supply line (LVDD1),
- at least one second buffer (55a, 55b, 55c, 55d) between the second portion and the second supply line (LVDD2), said first buffer having a current gain different from same of the second buffer.

13. The memory device according to claim 10, said circuit (60) comprising:
- a first portion (61) connected to the first supply line (LVDD1) and to a node receiving a voltage supply VDD,
- a second portion (62) connected to said node, at least one delay cell being disposed between the second portion and the second supply line (LVDD2).
